(19) **Europäisches Patentamt**

**European Patent Office**

**Office européen des brevets**

(11) **EP 1 376 680 A1**

(12) **EUROPÄISCHE PATENTANMELDUNG**

(43) Veröffentlichungstag:
02.01.2004 Patentblatt 2004/01

(51) Int Cl.⁷: **H01L 21/66**

(21) Anmeldenummer: 03012799.7

(22) Anmeldetag: **05.06.2003**

(84) Benannte Vertragsstaaten:
**AT BE BG CH CY CZ DE DK EE ES FI FR GB GR HU IE IT LI LU MC NL PT RO SE SI SK TR**
Benannte Erstreckungsstaaten:
**AL LT LV MK**

(30) Priorität: **21.06.2002 DE 10227829**

(71) Anmelder: **Infineon Technologies AG**
**81669 München (DE)**

(72) Erfinder:
• **Fischer, Armin**
**81825 München (DE)**
• **von Glasow, Alexander**
**82031 Grünwald (DE)**

(74) Vertreter: **Karl, Frank**
**Patentanwälte Kindermann,**
**Karl-Böhm-Strasse 1**
**85598 Baldham (DE)**

(54) **Verfahren zum Überwachen der Herstellung und zum Bewerten der Qualität einer Metallisierungsanordnung sowie zugehörige Erfassungsvorrichtung**

(57) Erläutert wird unter anderem ein Verfahren, bei dem ein Sollwert für den Temperaturkoeffizienten einer Metallisierungsanordnung vorgegeben wird (100). Nach der Herstellung (102) der Metallisierungsanord- nung wird für die Metallisierungsanordnung ein Istwert des Temperaturkoeffizienten ermittelt (104). Danach wird aufgrund eines Vergleichs von Istwert und Sollwert die Herstellung von Metallisierungsanordnungen über- wacht (118).

FIG 1

**Beschreibung**

Die Erfindung betrifft ein Verfahren zum Überwachen der Herstellung einer Metallisierungsanordnung, insbesondere einer integrierten Metallisierungsanordnung.

Die Metallisierungsanordnung ist beispielsweise eine Leitbahn oder eine Kontaktlochkette bzw. Viakette. Zum Überwachen der Herstellung lässt sich beispielsweise der Ohmsche Widerstand der Metallisierungsanordnung erfassen. So verändert sich der Ohmsche Widerstand beispielsweise dann, wenn die Metallisierungsanordnung breiter oder schmaler als eine Sollbreite gefertigt worden ist.

Es ist Aufgabe der Erfindung, zum Überwachen der Herstellung einer Metallisierungsanordnung ein einfaches Verfahren anzugeben, das im Vergleich zu bekannten Verfahren eine weitgehendere Überwachung der Herstellung und insbesondere auch der Prozessstabilität des Herstellungsprozesses gestattet. Außerdem sollen ein zugehöriges Verfahren zum Bewerten der Qualität der Metallisierungsanordnung sowie eine Erfassungsvorrichtung angegeben werden.

Die auf das Verfahren bezogene Aufgabe wird durch die im Patentanspruch 1 angegebenen Verfahrensschritte gelöst. Weiterbildungen sind in den Unteransprüchen angegeben.

Beim erfindungsgemäßen Verfahren wird ein Sollwert oder ein Sollbereich für eine physikalische Größe vorgegeben, die ein Maß für die Temperaturabhängigkeit des Ohmschen Widerstandes der herzustellenden Messanordnung ist. Die Metallisierungsanordnung wird hergestellt, beispielsweise unter Nutzung von üblichen Herstellungs- und Temperungsverfahren. Für die Metallisierungsanordnung wird ein Istwert für die physikalische Größe ermittelt. Aufgrund eines Vergleichs von Istwert und Sollwert bzw. Sollbereich wird die Herstellung der Metallisierungsanordnung oder einer anderen gleichzeitig hergestellten Metallisierungsanordnung überwacht, z.B. der einer im gleichen Herstellungsprozess hergestellte Metallisierungsanordnung einer integrierten Schaltungsanordnung.

Die Temperaturabhängigkeit des Ohmschen Widerstandes hängt stärker ab von der Mikrostruktur inklusive der Defekte der Metallisierungsanordnung als der Widerstand selbst. Damit lassen sich bei einer Auswertung der Temperaturabhängigkeit des Ohmschen Widerstandes auch Veränderungen der Mikrostruktur bei der Überwachung der Herstellung einbeziehen.

Die Mikrostruktur ist von besonderer Bedeutung für Metallisierungsanordnungen, die Ströme leiten, weil Zuverlässigkeitsaspekte wie die Elektromigration und die sogenannte Stressmigration maßgeblich durch die Mikrostruktur bestimmt werden. Insbesondere beeinflusst ein feinkörniges Gefüge mit kleinen mittleren Korngrößen oder ein Gefüge mit einer hohen Defektdichte die Bildung von Materialaussparungen bzw. sogenannten Voids durch die Freisetzung und die Ansammlung von Leerstellen während des Betriebs oder der Lagerung des Produktes. Die Folge sind Ausfälle während der Produktlebensdauer.

Das erfindungsgemäße Verfahren verkürzt außerdem die Reaktionsmöglichkeiten auf Veränderungen in der Mikrostruktur bei der Herstellung im Vergleich zum bisherigen Vorgehen erheblich. Das erfindungsgemäße Verfahren lässt sich nämlich innerhalb weniger Minuten ausführen, z.B. in einer Zeit ausführen, die kleiner als ein Stund ist. Im Wesentlichen muss vor der Ausführung von Rechenschritten nur der Widerstand bei zwei verschiedenen Temperaturen der Metallisierungsanordnung bestimmt werden. Dieser Vorgang lässt sich leicht automatisieren und damit auch sehr schnell ausführen.

Bisher waren dagegen Aussagen über die Mikrostruktur einer Metallisierungsanordnung erst nach der Durchführung von aufwendigen ortsauflösenden Verfahren oder integralen Verfahren möglich. Alle bisher eingesetzten Methoden erforderten eine aufwendige Probenvorbereitung, die mit einer Probenzerstörung verbunden war. Bei der Probenvorbereitung bestand außerdem das Risiko, dass die Mikrostruktur durch die Probenvorbereitung selbst beeinflusst wird. Die Durchführung der bekannten Verfahren zum Bestimmen der Mikrostruktur erforderte mehrere Stunden.

Bei einer Weiterbildung ist die Metallisierungsanordnung eine in einem Dielektrikum einer integrierten Schaltungsanordnung geführte Leitbahn. Obwohl das erfindungsgemäße Verfahren auch bei anderen Metallisierungsanordnungen eingesetzt werden kann, beispielsweise bei Profilstählen oder elektrischen Kabeln, ist es bei Leitbahnen integrierter Schaltungsanordnungen besonders wirkungsvoll einsetzbar, weil kleine Veränderungen in der Mikrostruktur aufgrund der geringen Abmessungen der Leitbahnen einen großen Einfluss auf die Zuverlässigkeit der Metallisierungsanordnung bei ihrer bestimmungsgemäßen Verwendung haben.

Bei einer nächsten Weiterbildung hat die Metallisierungsanordnung in mindestens einer Richtung eine Abmessung kleiner als hundert Mikrometer oder kleiner als ein Mikrometer. Insbesondere bei Strukturen kleiner als ein Mikrometer gibt es an der schmalsten Stelle der Leitbahn nur eine kleine Materialmenge, die bspw. durch Elektromigration oder Stressmigration vergleichsweise schnell abgetragen werden kann, wenn die Mikrostruktur von einer vorgegebenen Sollstruktur abweicht.

Bei einer nächsten Weiterbildung besteht die Metallisierungsanordnung aus Kupfer oder einer Kupferlegierung, die mindestens fünfzig Prozent oder mindestens neunzig Prozent Kupfer enthält. Bei der Herstellung von Leitbahnen integrierter Schaltungsanordnungen aus Kupfer oder einer Kupferlegierung muss ein sogenanntes Damascene-Verfahren angewendet werden, bei dem zuerst Gräben für die Leitbahn hergestellt werden, danach das Kupfer in den Gräben und oberhalb der Gräben abgelagert wird und schließlich eine Einebnung mit einem Polierprozess durchgeführt wird. Die Abscheidung des Kupfers in Gräben wirkt sich erheblich auf die Mikrostruktur des Kupfers in den Gräben aus. Insbesondere hat die Breite des Grabens einen Einfluss auf die Kornstruktur. Aufgrund dieses besonderen Herstellungsverfahrens treten Abweichungen in der Mikrostruktur häufiger auf, als bei anderen Herstellungsverfahren, beispielsweise bei der Herstellung von integrierten Leitbahnen aus Aluminium, bei der zunächst ganzflächig eine vergleichsweise ebene Aluminiumschicht abgeschieden wird.

Bei einer nächsten Weiterbildung des erfindungsgemäßen Verfahrens wird zum Bestimmen des Sollwertes mindestens ein Istwert für die physikalische Größe bei mindestens einer Metallisierungsanordnung ermittelt, die die gleiche äußere Struktur wie die herzustellende Metallisierungsanordnung hat und deren innere Struktur einer Sollstruktur entspricht. So lässt sich beispielsweise der Istwert eines vorangegangenen Herstellungsprozesses nutzen, z.B. eines Herstellungsprozesses am Vortag oder in der vorigen Woche. Die Übereinstimmung der inneren Struktur mit einer Sollstruktur lässt sich mit den bekannten Verfahren zum Ermitteln der Mikrostruktur ermitteln. Obwohl diese Verfahren aufwendig sind, sind sie zur Bestätigung der Richtigkeit eines Sollwertes geeignet, da sie nur einmal bei der Vorgabe des Sollwertes, nicht jedoch bei jeder Bestimmung eines Istwertes durchgeführt werden müssen. Als Verfahren zur Bestätigung der Richtigkeit des Sollwertes sind insbesondere geeignet:

- die Rasterelektronenmikroskopie,
- die Transmissionselektronenmikroskopie,
- die Analyse mit Hilfe eines fokussierten Ionenstrahls,
- das sogenannte automatische Kristall-Orientierungs-Mapping, oder
- eine Texturanalyse durch Röntgenbeugung.

Bei einer nächsten Weiterbildung des erfindungsgemäßen Verfahrens ist die physikalische Größe der Temperaturkoeffizient bei einer Referenztemperatur. Der Temperaturkoeffizient berücksichtigt neben der Temperaturabhängigkeit des Ohmschen Widerstandes auch die Größe des Widerstandes bei einer Referenztemperatur, z.B. bei einer der verschiedenen Temperaturen, für die der Widerstand ermittelt wird. Durch diese Maßnahme lässt sich der Einfluss vieler Einflussgrößen, die zwar den Widerstand beeinflussen, nicht aber den Temperaturkoeffizienten, auf die Überwachung verringern. Erst dadurch ist es möglich, um Größenordnungen kleinere Einflüsse zu erfassen als bei einer Überwachung des Widerstandes allein, beispielsweise Einflüsse der Mikrostruktur.

Bei einer nächsten Weiterbildung wird zum Ermitteln des Istwertes bei mindestens zwei verschiedenen Temperaturen der Widerstand der Metallisierungsanordnung ermittelt oder gemessen. Zum Ermitteln des Istwertes wird bei einer nächsten Weiterbildung das im Standard EIA/JESD33-A (Electronic Industries Association) angegebene Verfahren zum Ermitteln des Temperaturkoeffizienten bei einer Referenztemperatur ausgeführt. Das dort angegebene Verfahren ist besonders geeignet, um Erfassungsfehler auszuschließen bzw. deren Einfluss auf das Erfassungsergebnis zu verringern.

Bei einer Weiterbildung wird abhängig von der Abweichung des Istwertes vom Sollwert oder Sollbereich die Einhaltung eines Prozessparameters geprüft. Damit wird die Herstellung von Metallisierungsanordnungen nicht nur überwacht, sondern bildet auch den Ausgangspunkt für eine Fehlersuche. Die Fehlersuche ist einfach und effektiv, weil zuerst Prozessparameter geprüft werden, von denen die erfasste Größe am stärksten abhängt, nämlich Parameter, welche die Mikrostruktur am stärksten beeinflussen, beispielsweise:

- ein Prozessparameter mit einem maßgeblichen Einfluss auf die Größe von Kristalliten bzw. Körnern in der Metallisierungsanordnung, z.B. die Temperatur bei einem Tempervorgang, die Temperatur beim Aufbringen der Metallisierung, oder auch die ursprüngliche Dicke der Metallisierungsschicht nach dem Aufbringen,
- ein Prozessparameter, der die Form der Kristallite maßgeblich beeinflusst,
- ein Prozessparameter, der die Art oder den Anteil der vorhandenen Phasen maßgeblich beeinflusst,
- ein Prozessparameter, der die Substruktur der Kristallite maßgeblich beeinflusst, insbesondere hinsichtlich von Gitterfehlern, Leerstellen, Versetzungen, Stapelfehler oder Zwillingskristalliten, wobei beispielsweise eine Plasmabehandlung bzw. eine Ionenbestrahlung oder eine mechanische Krafteinwirkung einen maßgeblichen Einfluss haben, oder
- ein Prozessparameter, der die gegenseitige Anordnung und Ausrichtung der Kristallite und Phasenanteile maßgeblich beeinflusst.

Bei einer nächsten Weiterbildung des Verfahrens zum Überwachen der Herstellung wird bei einer Abweichung des Istwertes vom Sollwert oder vom Sollbereich automatisch eine Fehlermeldung in einer Datei vermerkt, oder auf einer Anzeigeeinheit ausgegeben. Das Vermerken in einer Datei eröffnet die Möglichkeit, mehrere Fehlermeldungen zusammen auszuwerten. Das Ausgeben auf einer Anzeigeeinheit ermöglicht es, ohne Zeitverzug auf die Abweichung zu reagieren.

Bei einer nächsten Weiterbildung des erfindungsgemäßen Verfahrens wird es in regelmäßigen Abständen bezogen auf die Anzahl prozessierter Metallisierungsanordnungen oder bezogen auf die Prozesszeit eines Produktionsprozesses durchgeführt. Die Anzahl bzw. die zwischen zwei Prüfungen liegende Prozesszeit hängt von der Prozessstabilität ab. Läuft die Produktion erst an, so wird beispielsweise aller zwei Tage geprüft. Ist der Produktionsprozess später stabil, so reicht eine wöchentliche Prüfung der Mikrostruktur aus.

Die Erfindung betrifft außerdem ein Verfahren zum Bewerten der Qualität einer Metallisierungsanordnung, bei dem die gleichen Verfahrensschritte wie beim Verfahren zum Überwachen der Herstellung ausgeführt werden. Jedoch wird aufgrund des Vergleichs nicht die Produktion überwacht, sondern es wird die Qualität der Metallisierungsanordnung bewertet. Hinsichtlich der technischen Wirkungen gelten die Ausführungen für das Verfahren zum Überwachen der Herstellung.

Bei einer Weiterbildung wird abhängig von der Qualität ein Verfahrensschritt zur weiteren Bearbeitung der Metallisierungsanordnung oder einer integrierten Schaltungsanordnung ausgeführt oder unterlassen. Beispielsweise wird eine integrierte Schaltungsanordnung nur dann mit einem Gehäuse umgeben, wenn die Metallisierungsanordnung die vorgegebene Mikrostruktur hat. Hat die Schaltungsanordnung nicht die vorgegebene Mikrostruktur, so wird sie nicht in ein Gehäuse eingefügt, sondern verworfen. Die Anlage zum Herstellen des Gehäuses lässt sich auf diese Art und Weise besser ausnutzen.

Das Verfahren zum Bewerten der Qualität wird bei einer Weiterbildung zum Vergleich von neuen Abscheideverfahren und/oder Temperverfahren bezüglich älterer Verfahren oder bezüglich anderer neuer Verfahren verwendet. Durch diese Maßnahme hat der Entwickler der neuen Verfahren eine sehr schnelle und kostengünstige Aussage über die Eignung der neuen Verfahren.

Die Erfindung betrifft außerdem eine Erfassungsvorrichtung, die zur Durchführung der erfindungsgemäßen Verfahren oder deren Weiterbildungen geeignet ist. Damit gelten die oben stehenden Ausführungen auch für die Erfassungsvorrichtung.

Im Folgenden werden Ausführungsbeispiele der Erfindung an Hand der beiliegenden Zeichnungen erläutert. Darin zeigen:

Figur 1     Verfahrensschritte zur Überwachung der Herstellung von integrierten Schaltkreisen,

Figur 2     die Abhängigkeit des Widerstandes einer Leitbahn von der Temperatur, und

Figur 3     die Mikrostruktur einer Leitbahn.

Das Verfahren beginnt in einem Verfahrensschritt 100 mit der Vorgabe eines unteren Sollwertes TKU und eines oberen Sollwertes TKO für den Temperaturkoeffizienten TK bei einer Referenztemperatur T1. Beispielsweise wird aufgrund der Erfahrungen bei vorangegangenen Produktionszyklen empirisch ein Wert $TKU = 0{,}00035\ °C^{-1}$ und $TKO = 0{,}00037\ °C^{-1}$ gewählt.

In einem folgenden Verfahrensschritt 102 wird ein Wafer mit einer Vielzahl von integrierten Schaltungsanordnungen und mehreren außerhalb der Schaltungsanordnungen angeordneten Teststrukturen aus der Fertigung entnommen. Mit Hilfe einer unten näher erläuterten Messvorrichtung wird in einem folgenden Verfahrensschritt 104 der Temperaturkoeffizient TK(T1) bei einer Referenztemperatur T1 automatisch nach dem Verfahren gemäß Standard EIA/JESD33-A ermittelt.

In einem Verfahrensschritt 106 wird der Ist-Temperaturkoeffizient TK(T1) mit dem unteren Sollwert TKU und dem oberen Sollwert TKO verglichen. Liegt der Ist-Temperaturkoeffizient TK(T1) zwischen dem unteren Sollwert TKU und dem oberen Sollwert TKO, so wird davon ausgegangen, dass die Mikrostruktur der Testleitbahn und damit auch die Mikrostruktur der mit denselben Prozessen hergestellten Leitbahnen der Schaltungsanordnung einer vorgegebenen Soll-Mikrostruktur entspricht. Nach dem Verfahrensschritt 106 folgt unmittelbar ein Verfahrensschritt 108, in welchem der Wafer der weiteren Prozessierung zugeführt wird. Die Prozessführung zur Herstellung der Leitbahnen wird nicht verändert.

Wird dagegen im Verfahrensschritt 106 festgestellt, dass der Ist-Temperaturkoeffizient TK nicht zwischen dem unteren Sollwert TKU und dem oberen Sollwert TKO liegt, so folgt nach dem Verfahrensschritt 106 unmittelbar ein Verfahrensschritt 110. Im Verfahrensschritt 110 wird eine Fehlermeldung erzeugt, die auf die Abweichung des Ist-Temperaturkoeffizienten TK(T1) vom Sollbereich hinweist. In einem dem Verfahrensschritt 110 folgenden Verfahrensschritt 112 wird der Wafer als nicht mehr zu prozessierend gekennzeichnet und aus der Produktion entnommen. Alternativ wird der Wafer als mindere Qualität gekennzeichnet und weiter prozessiert.

Nach dem Verfahrensschritt 108 und dem Verfahrensschritt 112 folgt ein Verfahrensschritt 114, in dem das Verfahren hinsichtlich des betrachteten Wafers beendet wird.

Eine gestrichelte Linie 116 verdeutlicht die Trennung der Auswirkungen bezüglich des geprüften Wafers und bezüglich anderer Wafer. Beim Auswerten der Fehlermeldung in einem Verfahrensschritt 118 muss nämlich die Ursache für die Abweichung gefunden werden. Diese Ursache wird bei Prozessparametern gesucht, welche die Mikrostruktur unmittelbar beeinflussen. Ist die Ursache für die Abweichung des Temperaturkoeffizienten beseitigt, so lassen sich andere Wafer ohne diese Abweichungen herstellen.

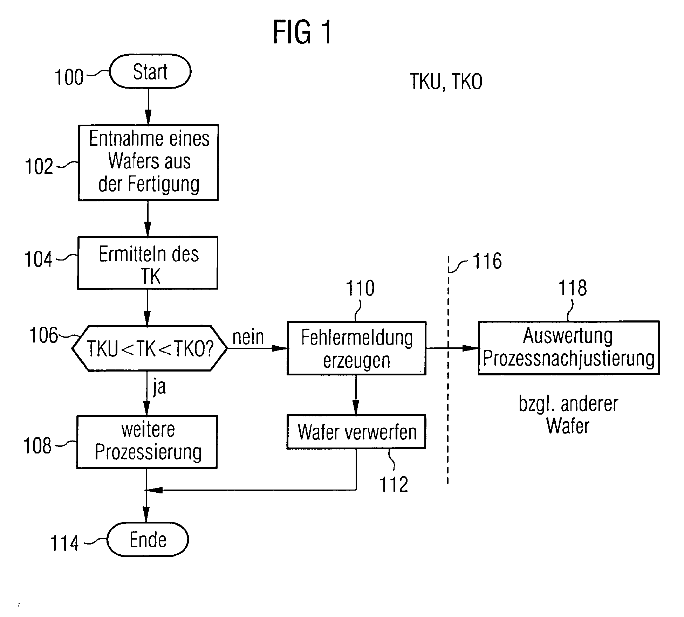

Das an Hand der Figur 1 erläuterte Verfahren lässt sich nach der Herstellung jeder Metallisierungslage einer Schaltungsanordnung mit mehreren Metallisierungslagen ausführen. Alternativ wird das Verfahren jedoch erst nach der Herstellung der letzten Metallisierungslage für Teststrukturen in allen Metallisierungslagen ausgeführt.

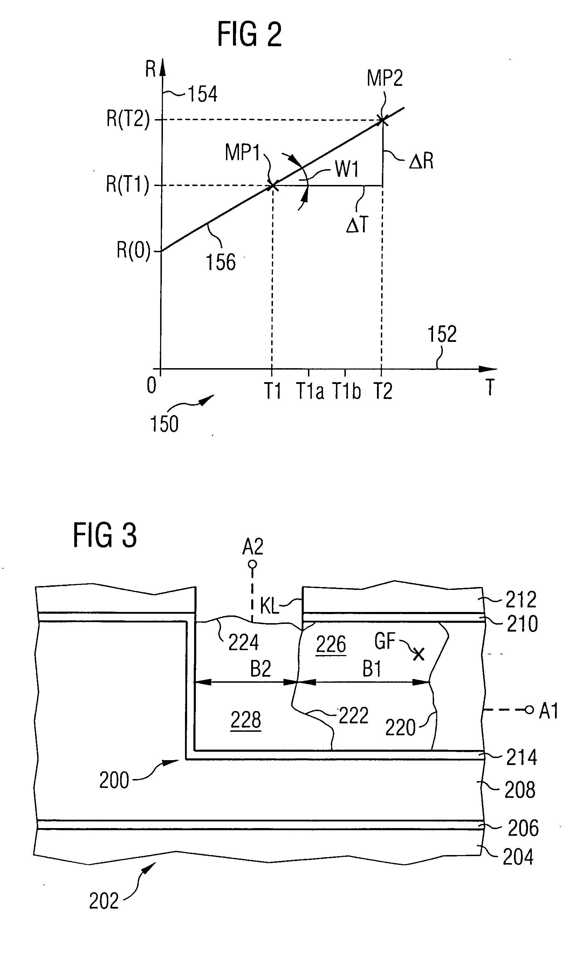

Figur 2 zeigt in einem Koordinatensystem 150 die Abhängigkeit des Widerstandes R einer Kupferleitbahn von der Temperatur T. Das Koordinatensystem 150 hat eine x-Achse 152 zum Darstellen der Werte der Temperatur T in °C (Grad Celsius) und eine y-Achse 154 zum Darstellen der Werte des Widerstandes R. Die Beziehung zwischen der Temperatur T und dem Widerstand R ist linear und wird durch eine Gerade 156 dargestellt, die einen Anstieg von etwa 45° hat und die y-Achse 154 oberhalb des Koordinatenursprungs bei einem Widerstandswert R0 schneidet. Eine Temperatur T1, die im Ausführungsbeispiel als Referenz-Temperatur für den Vergleich von Temperaturkoeffizienten dient, entspricht z.B. einer Umgebungstemperatur von 20°C. Eine Temperatur T2 hat z.B. den Wert 80°C und wird wie die Temperatur T1 zur Bestimmung des Temperaturkoeffizienten TK (T1) verwendet.

Der Temperaturkoeffizient TK(T1) ist gemäß der folgenden Formel festgelegt:

$$TK(T1) = 1/R(T1) \cdot \Delta R/\Delta T,$$

wobei R(T1) der für die Temperatur T1 ermittelte Ohmsche Widerstand der Leitbahn, $\Delta R$ die Differenz aus dem Widerstand R(T2) und R(T1) sowie $\Delta T$ die Differenz aus der Temperatur T2 und T1 sind. Das Verhältnis $\Delta R/\Delta T$ gibt den Anstieg A der Geraden 156 bzw. den Tangens eines Winkels W1 zwischen der Geraden 156 und der x-Achse 152 an.

Bei einem ersten Ausführungsbeispiel wird der Temperaturkoeffizient TK(T1) auf einfache Art und Weise dadurch bestimmt, dass zunächst der Widerstand R (T1) bei der Temperatur T1 gemessen wird. Anschließend wird der die Leitbahn tragende Wafer auf die Temperatur T2 von 80°C erwärmt. Bei dieser Temperatur wird dann der Widerstand R(T2) gemessen. Anschließend wird gemäß der oben angegebenen Formel der Temperaturkoeffizient TK(T1) berechnet.

Auch ein Verfahren mit Mittelwertbildung aus jeweils mehreren Messungen des Widerstandes R(T1) bzw. R(T2) wird angewandt.

Aus den Mittelwerten wird dann $\Delta R$ bestimmt. Auch Mittelwertbildungen über mehrerer erfasste Temperaturen T1 bzw. T2 werden durchgeführt, wenn die Messtemperatur schwankt.

Bei einem nächsten Ausführungsbeispiel wird der Temperaturkoeffizient mit Hilfe eines genaueren Verfahrens ermittelt, bei dem:

1. der Widerstand der Leitbahn bei vier Temperaturen T1, T1a, T1b und T2 bestimmt wird, die z.B. bei 20°C, 40°C, 60°C bzw. 80°C liegen.

2. Anschließend wird mit Hilfe einer Regressionsrechnung die Lage der Geraden 156 bestimmt, wobei der Anstieg der Geraden ermittelt wird. Außerdem wird dabei der Wert R(0) ermittelt, d.h. der Schnittpunkt mit der y-Achse 154.

3. Der Widerstand R(T1) der Leitbahn bei der Referenz-Temperatur T1 wird gemäß der folgenden Formel aus den Größen R(0) und dem Anstieg A berechnet:

$$R(T1) = R(0) + A \cdot T1.$$

4. Der Temperaturkoeffizient TK(T1) wird gemäß der folgenden Formel ermittelt:

$$TK(T1) = A/R(T1),$$

wobei R(T1) der im Schritt 3 ermittelte Wert ist.

Die Verfahrensschritte 1. bis 4. stimmen mit den in den Absätzen 4.3.1.1 bis 4.3.1.4 angegebenen Verfahrensschritten des Standards EIA/JESD33-A der EIA (Electronic Industries Association/ Solid State Technology Association, früher bekannt als Joint Electron Device Engineering Council) "Standard method for measuring and using the temperature coefficient of resistance to determine the temperature of a metallization line", October 1995, überein.

Bei einem nächsten Ausführungsbeispiel werden auch alle anderen Bedingungen erfüllt, die der Standard EIA/JESD33-A an das Bestimmen des Temperaturkoeffizienten TCR(Tref) stellt. Werden bspw. mehr als vier Messungen in die Regressionsrechnung einbezogen, so erhöht sich die Genauigkeit bei der Ermittlung des Temperaturkoeffizienten TK(T1).

Figur 3 zeigt die Mikrostruktur einer Leitbahn 200, die Teil einer Teststruktur für eine integrierte Schaltungsanordnung 202 ist. Ein Halbleitersubstrat der integrierten Schaltungsanordnung 202 ist in Figur 3 nicht dargestellt. Jedoch sind auf dem Substrat angeordnete Schichten dargestellt, in denen sich die Leitbahn 200 befindet. Ausgehend vom Substrat gibt es in der integrierten Schaltungsanordnung 202 die folgenden Schichten:

- eine elektrische Isolierschicht 204, beispielsweise aus Siliziumdioxid oder einem sogenannten low-k-Material (k bezeichnet die Dielektrizitätskonstante), eine Zwischenschicht 206, z.B. aus Siliziumnitrid oder Siliziumcarbid,

- eine Isolierschicht 208, z.B. aus Siliziumdioxid, eine Zwischenschicht 210, z.B. aus Siliziumnitrid oder Siliziumcarbid, und eine obere Isolierschicht 212, z. B. aus Siliziumdioxid.

Die Leitbahn 200 wurde mit Hilfe eines Dualen-Damascene-Verfahrens in die Isolierschicht 208 eingebracht. Eine Linerschicht 214, beispielsweise aus Titannitrid, Tantalnitrid bzw. Tantal, trennt die Leitbahn 200 von der Isolierschicht 208.

In Figur 3 sind Korngrenzen 220, 222 und 224 zweier Kristallite 226 und 228 bzw. Körner der Leitbahn 200 dargestellt. Der durch die Korngrenzen 220 und 222 begrenzte Kristallit 226 hat in tangentialer Richtung zur Oberfläche des Halbleitersubstrats eine Breite B1 von bspw. 350 nm, die etwa der Breite der Leitbahn 200 entspricht. Der durch die Korngrenzen 222 und 224 begrenzte Kristallit 228 hat eine Breite B2, die etwas kleiner als die Breite B1 ist. Außerdem ist in Figur 3 ein Gitterfehler GF im Kristallit 226 durch ein Kreuz dargestellt.

Beim Durchführen des an Hand der Figur 1 erläuterten Verfahrens wird ein konstanter Messstrom über Anschlüsse A1 und A2 in die Leitbahn 200 eingespeist. Gleichzeitig wird der Spannungsabfall entlang der Leitbahn 200 gemessen. Aus diesen beiden Größen wird der Widerstand bestimmt. Bei einem alternativen Verfahren wird an den Anschlüssen A1 und A2 eine konstante Spannung angelegt. Der Strom durch die Leitbahn 200 wird erfasst. Anschließend wird wiederum aus den beiden Größen der Widerstand berechnet.

Eine Messvorrichtung zum Ermitteln des Temperaturkoeffizienten TK enthält bei einem Ausführungsbeispiel:

- eine Haltevorrichtung zum Halten des Wafers, z.B. einen sogenannten Wafer-Chuck,
- Anschlusselektroden zum Anschließen der Konstantstromquelle an die Anschlüsse A1 und A2, z. B. eine sogenannte Nadelkarte,
- eine Heizeinrichtung, z.B. ein Heizbarer Wafer-Chuck zur externen Waferheizung oder ein in den Wafer integrierter Heizer, der z.B. Polysiliziumstreifen enthält und dessen Temperatur z.B. über eine in den Wafer integrierte Diode überwacht wird,
- und eine Steuereinheit, welche die an Hand der Figur 1 erläuterten Verfahrensschritte 104, 106 und 110 automatisch ausführt. Die Steuereinrichtung ist entweder eine elektronische Schaltung ohne Prozessor oder eine elektronische Datenverarbeitungsanlage, die einen Prozessor enthält, der Befehle eines Programms ausführt.

Bei einem anderen Ausführungsbeispiel wird der Temperaturkoeffizient einer kurzen Leitbahn und einer langen Leitbahn ermittelt. Aus dem Vergleich der Temperaturkoeffizienten für beide Leitbahnen werden Rückschlüsse auf die Dichte von Gitterfehlern GF oder von anderen Defekten gezogen.

Als Referenztemperatur Tref ist grundsätzlich jede Temperatur geeignet, z.B. auch eine Temperatur von 0°C. In den oben angegebenen Formeln, insbesondere in den Formeln der Schritte 1. bis 4., ist dann an Stelle der Temperatur T1 die Referenztemperatur Tref einzusetzen. An Stelle der Größen R(T1) und TK(T1) treten die Größen R(Tref) bzw. TK(Tref) auf.

**Patentansprüche**

1. Verfahren zum Überwachen der Herstellung einer Metallisierungsanordnung (200), insbesondere einer integrierten Metallisierungsanordnung (200),

bei dem ein Sollwert (TKU) oder ein Sollbereich (TKU, TKO) für eine physikalische Größe (TK) vorgegeben wird, die ein Maß für die Temperaturabhängigkeit des elektrischen Widerstandes (R) einer herzustellenden Metallisierungsanordnung (200) ist (100),

bei dem die Metallisierungsanordnung (200) hergestellt wird (102),

bei dem für die Metallisierungsanordnung (200) ein Istwert (TK(T1)) für die physikalische Größe (TK) ermittelt wird (104),

und bei dem aufgrund eines Vergleichs von Istwert (TK(T1)) und Sollwert (TKU) oder Sollbereich (TKU, TKO) die Herstellung der Metallisierungsanordnung (202) oder die Herstellung mindestens einer gleichzeitig mit der Metallisierungsanordnung (202) hergestellten anderen Metallisierungsanordnung oder ein Herstellungsprozess zum Herstellen von Metallisierungsanordnungen (202) überwacht wird (106).

2. Verfahren nach Anspruch 1, **dadurch gekennzeichnet, dass** die Metallisierungsanordnung (200) eine in einem Dielektrikum (208) einer integrierten Schaltungsanordnung (202) geführte Leitbahn ist,

und/oder dass die Metallisierungsanordnung in mindestens einer Richtung eine Abmessung kleiner hundert Mikrometer oder kleiner als ein Mikrometer hat,

und/oder dass die Metallisierungsanordnung (200) aus Kupfer oder einer Kupferlegierung besteht, die mindestens fünfzig Prozent Kupfer enthält.

3. Verfahren nach Anspruch 1 oder 2, **dadurch gekennzeichnet, dass** zur Bestimmung des Sollwertes (TKU) oder des Sollbereiches (TKU, TKO) mindestens ein Istwert für die physikalische Größe (TK) für mindestens eine Metallisierungsanordnung ermittelt wird, die die gleiche äußere Struktur wie die herzustellende Metallisierungsanordnung (200) hat und/oder deren innere Struktur einer Sollstruktur entspricht.

4. Verfahren nach einem der vorhergehenden Ansprüche, **dadurch gekennzeichnet, dass** die physikalische Größe der Temperaturkoeffizient (TK) bei einer Referenztemperatur (T1) ist.

5. Verfahren nach einem der vorhergehenden Ansprüche, **dadurch gekennzeichnet, dass** zum Ermitteln des Istwertes (TK(T1)) der Widerstand (R) der Metallisierungsanordnung (200) bei mindestens zwei verschiedenen Temperaturen (T1, T2) ermittelt und/oder gemessen wird,

und/oder dass zum Ermitteln des Istwertes (TK(T1)) das in dem Standard EIA/JESD33-A oder einem auf diesen Standard aufbauenden Standard angegebene Verfahren zum Ermitteln des Temperaturkoeffizienten (TCR) bei einer Referenztemperatur (Tref) ausgeführt wird.

6. Verfahren nach einem der vorhergehenden Ansprüche, **dadurch gekennzeichnet, dass** bei einer Abweichung des Istwertes (TK(T1)) vom Sollwert (TKU) oder vom Sollbereich (TKU, TKO) zuerst die Einhaltung eines Prozessparameters geprüft wird, der einen maßgeblichen Einfluss auf die Größe von Kristalliten (226, 228) in der Metallisierungsanordnung (200) hat, vorzugsweise die Temperatur eines Temperofens oder einer Sputteranlage,
und/oder die Einhaltung eines Parameters, der die Form der Kristallite (226, 228) maßgeblich beeinflusst,
und/oder die Einhaltung eines Parameters, der Art und/oder den Anteil der in der Metallisierungsanordnung (200) vorhandenen Phasen maßgeblich beeinflusst,
und/oder die Einhaltung eines Parameters, der die Substruktur der Kristallite (226, 228) maßgeblich beeinflusst, insbesondere hinsichtlich von Gitterfehlern (GF) und/oder Leerstellen und/oder Versetzungen und/oder Stapelfehlern und/oder Zwillingskristalliten,
und/oder die Einhaltung eines Parameters, der die gegenseitige Anordnung und Ausrichtung der Kristallite (226, 228) und/oder der Phasenanteile zueinander maßgeblich beeinflusst.

7. Verfahren nach einem der vorhergehenden Ansprüche, **dadurch gekennzeichnet, dass** bei einer Abweichung des Istwertes (TK(T1)) vom Sollwert (TKU) oder vom Sollbereich (TKU, TKO) automatisch eine Fehlermeldung in einer Datei vermerkt oder auf einer Anzeigeeinheit ausgegeben wird (110).

8. Verfahren nach einem der vorhergehenden Ansprüche, **dadurch gekennzeichnet, dass** es in regelmäßigen Abständen bezogen auf die Anzahl prozessierter Metallisierungsanordnungen oder die Prozesszeit des gleichen Produktionsprozesses durchgeführt wird.

9. Verfahren zum Bewerten der Qualität einer Metallisierungsanordnung (200), insbesondere einer integrierten Metallisierungsanordnung,
bei dem ein Sollwert (TKU) oder ein Sollbereich (TKU, TKO) für eine physikalische Größe (TK) vorgegeben wird, die ein Maß für die Temperaturabhängigkeit des elektrischen Widerstandes (R) einer herzustellenden Metallisierungsanordnung (200) ist (100),
bei dem die Metallisierungsanordnung (200) hergestellt wird (102),
bei dem für die Metallisierungsanordnung (200) ein Istwert (TK (T1)) für die physikalische Größe (TK) ermittelt wird (104),
und bei dem aufgrund eines Vergleichs von Istwert (TK(T1)) und Sollwert (TKU) oder Sollbereich (TKU, TKO) die Qualität der Metallisierungsanordnung (200) bewertet wird.

10. Verfahren nach Anspruch 9, **dadurch gekennzeichnet, dass** abhängig von der Qualität ein Verfahrensschritt zur weiteren Bearbeitung der Metallisierungsanordnung (200) oder zur weiteren Bearbeitung einer integrierten Schaltungsanordnung (202) ausgeführt oder unterlassen wird (108, 112).

11. Verfahren nach Anspruch 9 oder 10, **gekennzeichnet durch** mindestens einen Verfahrensschritt nach einem der Ansprüche 1 bis 8.

12. Verfahren nach einem der Ansprüche 9 bis 11, **dadurch gekennzeichnet, dass** es zum Vergleichen von neuen Abscheideverfahren und/oder Temperverfahren bezüglich älterer Verfahren oder bezüglich anderer neuer Verfahren verwendet wird.

13. Erfassungsvorrichtung für die Überwachung der Herstellung einer Metallisierungsanordnung,
mit einer Halteeinrichtung für eine Metallisierungsanordnung oder für ein die Metallisierungsanordnung (200) tragendes Substrat,
mit Anschlusselektroden zum Einspeisen eines Messstroms in oder zum Anlegen einer Messspannung an die Metallisierungsanordnung (200),
mit einer Erfassungseinrichtung zum Erfassen einer Spannung an oder eines Stromes durch die Metallisierungsanordnung (200),
mit einer Heizeinrichtung,
mit einer Temperatureinstelleinrichtung oder Temperaturregeleinrichtung,
und mit einer Steuereinheit,
wobei die Steuereinheit nach dem Aufnehmen der Metallisierungsanordnung (200) in die Halteeinrichtung automatisch eine physikalische Größe (TK) ermittelt, die ein Maß für die Temperaturabhängigkeit des elektrischen Widerstandes (R) der Metallisierungsanordnung (200) ist.

14. Erfassungsvorrichtung nach Anspruch 13, **gekennzeichnet durch** eine Speichereinheit, die einen vorgegebenen Sollwert (TKU) oder Werte (TKU, TKO) eines Sollbereiches speichert,
**durch** eine Vergleichseinheit, die einen Istwert (TK (T1)) der physikalischen Größe mit dem Sollwert (TKU) oder mit den Werten (TKU, TKO) des Sollbereiches vergleicht,
und **durch** eine Fehlermeldungseinheit, die abhängig vom Vergleichsergebnis automatisch eine Fehlermeldung erzeugt.

**15.** Erfassungsvorrichtung nach Anspruch 13 oder 14, **gekennzeichnet durch** Einheiten, bei deren Betrieb mindestens ein Verfahrensschritt eines Verfahrens nach einem der Ansprüche 1 bis 12 ausgeführt wird.

# FIG 1

100 — ( Start )

TKU, TKO

102 — | Entnahme eines Wafers aus der Fertigung |

104 — | Ermitteln des TK |

106 — ⟨ TKU < TK < TKO? ⟩ —nein→ | Fehlermeldung erzeugen | 110

116

118

| Auswertung Prozessnachjustierung |

bzgl. anderer Wafer

ja

108 — | weitere Prozessierung |

| Wafer verwerfen | 112

114 — ( Ende )

## FIG 2

## FIG 3

Europäisches Patentamt

**EUROPÄISCHER RECHERCHENBERICHT**

Nummer der Anmeldung

EP 03 01 2799

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.7) |
|---|---|---|---|
| X | EP 0 448 273 A (AMERICAN TELEPHONE & TELEGRAPH) 25. September 1991 (1991-09-25) | 1-3,5-12 | H01L21/66 |
| Y | * Spalte 3, Zeile 19 - Spalte 7, Zeile 29; Ansprüche 9,13,16 *<br>--- | 4,14 | |
| X | US 4 483 629 A (PASCO ROBERT W ET AL) 20. November 1984 (1984-11-20) | 13,15 | |
| Y | * Spalte 2, Zeile 30 - Spalte 8, Zeile 11; Abbildungen 1,2 *<br>--- | 4,14 | |
| X | EP 0 253 746 A (UNIV SYRACUSE) 20. Januar 1988 (1988-01-20) | 13 | |
| A | * Seite 2, Zeile 5 - Seite 3, Zeile 39 *<br><br>--- | 1-12,14, 15 | |
| X | US 5 260 668 A (MALLORY CHESTER L ET AL) 9. November 1993 (1993-11-09) | 13 | |
| A | * Spalte 1, Zeile 65 - Spalte 2, Zeile 68; Abbildung 1 *<br>----- | 1-12,14, 15 | |
| | | | RECHERCHIERTE SACHGEBIETE (Int.Cl.7)<br><br>H01L<br>G01N |

Der vorliegende Recherchenbericht wurde für alle Patentansprüche erstellt

| Recherchenort | Abschlußdatum der Recherche | Prüfer |
|---|---|---|
| MÜNCHEN | 6. Oktober 2003 | Neumann, A |

EPO FORM 1503 03.82 (P04C03)

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

& : Mitglied der gleichen Patentfamilie, übereinstimmendes Dokument

## ANHANG ZUM EUROPÄISCHEN RECHERCHENBERICHT
## ÜBER DIE EUROPÄISCHE PATENTANMELDUNG NR.

EP 03 01 2799

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-10-2003

| Im Recherchenbericht angeführtes Patentdokument | | Datum der Veröffentlichung | Mitglied(er) der Patentfamilie | | Datum der Veröffentlichung |
|---|---|---|---|---|---|
| EP 0448273 | A | 25-09-1991 | DE | 69104248 D1 | 03-11-1994 |
| | | | DE | 69104248 T2 | 26-01-1995 |
| | | | EP | 0448273 A1 | 25-09-1991 |
| | | | HK | 188595 A | 22-12-1995 |
| | | | JP | 4223355 A | 13-08-1992 |
| | | | SG | 9590332 A2 | 01-09-1995 |
| | | | US | 5264377 A | 23-11-1993 |
| US 4483629 | A | 20-11-1984 | US | RE32625 E | 15-03-1988 |
| EP 0253746 | A | 20-01-1988 | US | 4739258 A | 19-04-1988 |
| | | | DE | 3767063 D1 | 07-02-1991 |
| | | | EP | 0253746 A1 | 20-01-1988 |
| | | | JP | 63051654 A | 04-03-1988 |
| US 5260668 | A | 09-11-1993 | KEINE | | |

EPO FORM P0461

Für nähere Einzelheiten zu diesem Anhang : siehe Amtsblatt des Europäischen Patentamts, Nr.12/82